(19) Europäisches Patentamt / European Patent Office / Office européen des brevets

(11) **EP 3 660 524 B1**

(12) **FASCICULE DE BREVET EUROPEEN**

(45) Date de publication et mention de la délivrance du brevet:
**09.06.2021 Bulletin 2021/23**

(51) Int Cl.:
**G01R 31/26** *(2020.01)* **H02S 50/10** *(2014.01)*
**G01R 31/40** *(2020.01)*

(21) Numéro de dépôt: **19211268.8**

(22) Date de dépôt: **25.11.2019**

(54) **PROCÉDÉ DE DÉTERMINATION D'UNE COURBE COURANT-TENSION CORRIGÉE CARACTÉRISTIQUE D'UN SYSTÈME ÉLECTRIQUE**

VERFAHREN ZUR BESTIMMUNG EINER KORRIGIERTEN CHARAKTERISTISCHEN STROM-SPANNUNGS-KURVE EINES ELEKTRISCHEN SYSTEMS

METHOD FOR DETERMINING A CORRECTED CHARACTERISTIC CURRENT-VOLTAGE CURVE OF AN ELECTRICAL SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2018 FR 1871975**

(43) Date de publication de la demande:
**03.06.2020 Bulletin 2020/23**

(73) Titulaire: **Commissariat à l'Énergie Atomique et aux Énergies Alternatives**
**75015 Paris (FR)**

(72) Inventeurs:
• **LESPINATS, Sylvain**
**38054 Grenoble Cedex 9 (FR)**
• **AMHAL, Mohamed**
**38054 Grenoble Cedex 9 (FR)**

(74) Mandataire: **INNOV-GROUP**
**310, avenue Berthelot**
**69372 Lyon Cedex 08 (FR)**

(56) Documents cités:
**JP-A- S5 877 672**

• **SPERTINO FILIPPO ET AL: "PV Module Parameter Characterization From the Transient Charge of an External Capacitor", IEEE JOURNAL OF PHOTOVOLTAICS, I E E E, US, vol. 3, no. 4, 1 octobre 2013 (2013-10-01), pages 1325-1333, XP011527214, ISSN: 2156-3381, DOI: 10.1109/JPHOTOV.2013.2271191 [extrait le 2013-09-18]**

EP 3 660 524 B1

**Description**

**Domaine technique de l'invention**

La présente invention se rapporte un procédé de détermination d'une courbe courant-tension corrigée caractéristique d'un système électrique.

Le système électrique pourra notamment être un système de type photovoltaïque, tel qu'une cellule photovoltaïque, un module photovoltaïque comportant plusieurs cellules photovoltaïques ou une chaîne de modules photovoltaïques.

L'invention concerne également un dispositif de détermination de la courbe courant-tension corrigée d'un système électrique, ledit dispositif étant apte à mettre en œuvre ledit procédé.

**Etat de la technique**

Il est connu que le fonctionnement de certains systèmes électriques peut être caractérisé par une courbe courant-tension, également appelée courbe I-V. Une telle courbe permet en effet de connaître le courant produit par le système électrique en fonction de la tension qui est présente à ses bornes. Il est alors possible de suivre l'état de fonctionnement du système en établissant sa courbe I-V à partir de mesures et éventuellement de diagnostiquer son état de fonctionnement à partir de la courbe obtenue.

Il est notamment connu de procéder de la sorte dans un système photovoltaïque. La présence d'un défaut dans une chaîne de modules photovoltaïques handicape en effet la production d'électricité de toute la chaîne et donc de toute l'installation. Il est donc nécessaire de surveiller l'état de fonctionnement de chaque module photovoltaïque d'une chaîne afin de repérer un éventuel défaut au niveau d'un module et d'y pallier le plus rapidement possible.

Afin de vérifier l'état de fonctionnement d'un module, la plupart des solutions se basent notamment sur l'analyse des courbes I-V. C'est le cas par exemple dans les solutions décrites dans les demandes de brevets US2015/094967A1, WO2012/128807A1, FR2956213A1, WO2010/118952A1, US9048781B2, JP S58 77672A, US2014/266294A1 ainsi que dans la publication "SPERTINO FILIPPO et Al. : "PV Module Parameter Characterization from the transient charge of an external capacitor" - IEEE Journal of photovoltaics, IEEE, US, vol 3, n°4, 1 octobre 2013, pages 1325-1333, XP011527214.

De manière connue, un module photovoltaïque est en effet caractérisé par un ensemble de courbes I-V de référence pour différents niveaux d'ensoleillement (exprimés en Watt/m$^2$). Autrement dit, pour un niveau d'ensoleillement donné (appelé irradiance), un module photovoltaïque sain, c'est-à-dire non défaillant, sera théoriquement capable de suivre l'une des courbes I-V de référence pour ce niveau d'ensoleillement et de température. En revanche, si un module présente un défaut en fonctionnement, sa courbe I-V s'éloigne alors de cette courbe de référence pour ce niveau d'ensoleillement et de température.

Pour effectuer un diagnostic fiable, il est bien entendu nécessaire que les mesures soient fiables et que celles-ci reflètent bien l'état de fonctionnement du système photovoltaïque surveillé.

Or, il est bien connu de l'homme du métier que dans un système photovoltaïque, les mesures peuvent être déformées par un ensemble d'effets parasites de type capacitifs et inductifs (dans les cellules photovoltaïques, les modules, les câbles, le système de mesures, etc...). Ces effets parasites entrainent des déformations dans les données de mesure. A titre d'exemple, ces effets parasites peuvent se manifester par un écart entre la courbe I-V dite "Aller" (courbe mesurée en faisant varier la tension dans un premier sens, croissant ou décroissant) et la courbe I-V dite "Retour" (courbe mesurée en faisant varier la tension dans le sens opposé, respectivement décroissant ou croissant). L'effet de type capacitif est notamment non négligeable et il est d'autant plus important que le temps de mesure est court, par exemple de l'ordre de 20ms pour établir toute la courbe I-V.

Comme il existe un intérêt certain à effectuer des mesures dans un temps très court, notamment pour s'affranchir des variations de conditions de fonctionnement (température, ensoleillement pour un système photovoltaïque), pour ne pas avoir à perturber le fonctionnement normal de l'installation par déconnexion de l'onduleur, pour limiter autant que possible les pertes énergétiques associées et pour éviter les pertes Joule engendrant une chaleur à dissiper, il s'avère nécessaire d'obtenir des courbes I-V fiables.

Par ailleurs, on peut noter que les solutions antérieures connues ne sont souvent pas applicables quand on souhaite obtenir une courbe I-V complète, suffisamment échantillonnée et mesurée sur un temps très court (par exemple dans un but de diagnostic à partir de la courbe I-V).

Le but de l'invention est donc de proposer une solution qui permet de caractériser les effets parasites qui se manifestent lors d'une mesure de type I-V sur un système électrique, afin d'obtenir une courbe I-V qui est corrigée et exploitable, par exemple pour mettre en œuvre un diagnostic du système.

La solution de l'invention pourra notamment être adaptée à un système électrique tel qu'un système photovoltaïque. Elle présente un avantage certain lorsque le temps de mesure est particulièrement court, de l'ordre de 20ms.

**Exposé de l'invention**

Ce but est atteint par un procédé de détermination d'une courbe courant-tension corrigée d'un système électrique qui comporte deux bornes et qui est destiné à délivrer un courant électrique en fonction d'une tension de sortie entre ses deux bornes, ledit procédé comportant les étapes suivantes :

- Obtention d'une première courbe courant-tension caractéristique du système électrique, en faisant varier la tension à ses bornes à une première vitesse de mesure,
- Obtention d'une deuxième courbe courant-tension caractéristique du système électrique, en faisant varier la tension à ses bornes à une deuxième vitesse de mesure, différente de la première vitesse
- Détermination de plusieurs points de fonctionnement en tension appartenant à la fois à la première courbe courant-tension et à la deuxième courbe courant-tension,
- Modélisation par une unique capacité fictive d'un effet parasite intrinsèque à corriger entre une tension d'entrée dépourvue dudit effet parasite et ladite tension de sortie,
- Ledit procédé comportant, pour chaque point de fonctionnement en tension, une étape de détermination d'une valeur de correction représentative dudit effet parasite et une étape de détermination d'une valeur de courant corrigée à partir de la valeur de correction déterminée.

Selon une particularité, la première courbe courant-tension est obtenue en faisant varier la tension dans le sens croissant et la deuxième courbe courant-tension est obtenue en faisant varier la tension dans le sens décroissant.

Selon une autre particularité, le système électrique est de type photovoltaïque et le procédé comporte :

- Pour chaque point de fonctionnement en tension obtenu, une étape de détermination, à partir de la première courbe courant-tension, d'un premier courant et d'une première pente de variation de tension en fonction du temps et une étape de détermination, à partir de la deuxième courbe courant-tension, d'un deuxième courant et d'une deuxième pente de variation de tension en fonction du temps,
- Pour chaque point de fonctionnement en tension, ladite valeur de correction étant déterminée à partir dudit premier courant, de ladite première pente, dudit deuxième courant et de ladite deuxième pente.

Selon une autre particularité, ladite valeur de correction dudit effet parasite s'exprime par la relation suivante :

$$g(V) = \frac{I_A(V) - I_R(V)}{\frac{dV_R}{dt}(V) - \frac{dV_A}{dt}(V)}$$

Dans laquelle :

g(V) correspond audit effet parasite à éliminer ;
$I_A(V)$ correspond audit premier courant ;
$I_R(V)$ correspond audit deuxième courant ;
$\frac{dV_A}{dt}(V)$ correspond à ladite première pente ;
$\frac{dV_R}{dt}(V)$ correspond à ladite deuxième pente ;

Selon une autre particularité, l'étape de détermination de plusieurs points de fonctionnement en tension appartenant à la fois à la première courbe courant-tension et à la deuxième courbe courant-tension est mise en œuvre en employant une méthode d'interpolation.

L'invention concerne également un dispositif de détermination d'une courbe courant-tension corrigée d'un système électrique qui comporte deux bornes et qui est destiné à délivrer un courant électrique en fonction d'une tension de sortie entre ses deux bornes, ledit dispositif comportant :

- Des moyens de mesure d'une première courbe courant-tension caractéristique du système électrique, en faisant varier la tension à ses bornes à une première vitesse de mesure,
- Des moyens de mesure d'une deuxième courbe courant-tension caractéristique du système électrique, en faisant varier la tension à ses bornes à une deuxième vitesse de mesure, distincte de la première vitesse de mesure,

- Un module de détermination de plusieurs points de fonctionnement en tension appartenant à la fois à la première courbe courant-tension et à la deuxième courbe courant-tension,
- Un module de modélisation par une unique capacité fictive d'un effet parasite à corriger entre une tension d'entrée dépourvue dudit effet parasite et ladite tension de sortie,
- Ledit dispositif exécutant, pour chaque point de fonctionnement en tension, un module de détermination d'une valeur de correction représentative dudit effet parasite et un module de détermination d'une valeur de courant corrigée à partir de la valeur de correction déterminée.

Selon une particularité, la première courbe courant-tension est obtenue en faisant varier la tension dans le sens croissant et la deuxième courbe courant-tension est obtenue en faisant varier la tension dans le sens décroissant.

Selon une autre particularité, le système électrique est de type photovoltaïque et le dispositif comporte :

- Pour chaque point de fonctionnement en tension obtenu, un module de détermination, à partir de la première courbe courant-tension, d'un premier courant et d'une première pente de variation de tension en fonction du temps et un module de détermination, à partir de la deuxième courbe courant-tension, d'un deuxième courant et d'une deuxième pente de variation de tension en fonction du temps, et en ce que
- Pour chaque point de fonctionnement en tension, ladite valeur de correction étant déterminée à partir dudit premier courant, de ladite première pente, dudit deuxième courant et de ladite deuxième pente.

Selon une autre particularité, ladite valeur de correction dudit effet parasite s'exprime par la relation suivante :

$$g(V) = \frac{I_A(V) - I_R(V)}{\frac{dV_R}{dt}(V) - \frac{dV_A}{dt}(V)}$$

Dans laquelle :

g(V) correspond audit effet parasite à éliminer ;
$I_A(V)$ correspond audit premier courant ;
$I_R(V)$ correspond audit deuxième courant ;

$\frac{dV_A}{dt}(V)$ correspond à ladite première pente ;

$\frac{dV_R}{dt}(V)$ correspond à ladite deuxième pente ;

Selon une autre particularité, le module de détermination de plusieurs points de fonctionnement en tension appartenant à la fois à la première courbe courant-tension et à la deuxième courbe courant-tension est configuré pour mettre en œuvre une méthode d'interpolation.

L'invention concerne également l'utilisation du procédé tel que défini ci-dessus pour déterminer la courbe courant-tension caractéristique d'un système électrique de type photovoltaïque.

**Brève description des figures**

D'autres caractéristiques et avantages vont apparaître dans la description détaillée qui suit faite en regard des dessins annexés dans lesquels :

- La figure 1 illustre de manière schématique le principe de fonctionnement de l'invention.
- La figure 2 représente de manière schématique un module photovoltaïque.
- La figure 3A représente les courbes I-V de référence d'un système photovoltaïque et la figure 3B représente deux courbes I-V d'un système photovoltaïque, respectivement lorsque le système est sans défaut et lorsque le système est défaillant.
- Les figures 4A et 4B représentent deux schémas de modélisation équivalents des effets parasites présents dans un système photovoltaïque lors d'une mesure I-V.
- La figure 5 représente un schéma de modélisation des effets parasites présents dans un système photovoltaïque lors d'une mesure I-V, ledit schéma étant simplifié par rapport aux schémas des figures 4A et 4B.
- La figure 6 représente un schéma illustrant le principe de fonctionnement de l'invention.

- Les figures 7 et 8 représentent plusieurs diagrammes illustrant la fiabilité et l'efficacité de la solution de l'invention.

**Description détaillée d'au moins un mode de réalisation**

L'invention vise à obtenir une courbe corrigée I*-V d'un système électrique 1, cette courbe corrigée I*-V reflétant l'état de fonctionnement réel du système électrique. Par état de fonctionnement réel, on veut dire l'état de fonctionnement dont on a retiré les effets parasites de type capacitifs et inductifs susceptibles de venir perturber les mesures et donc de fausser les potentiels diagnostics à effectuer sur le système.

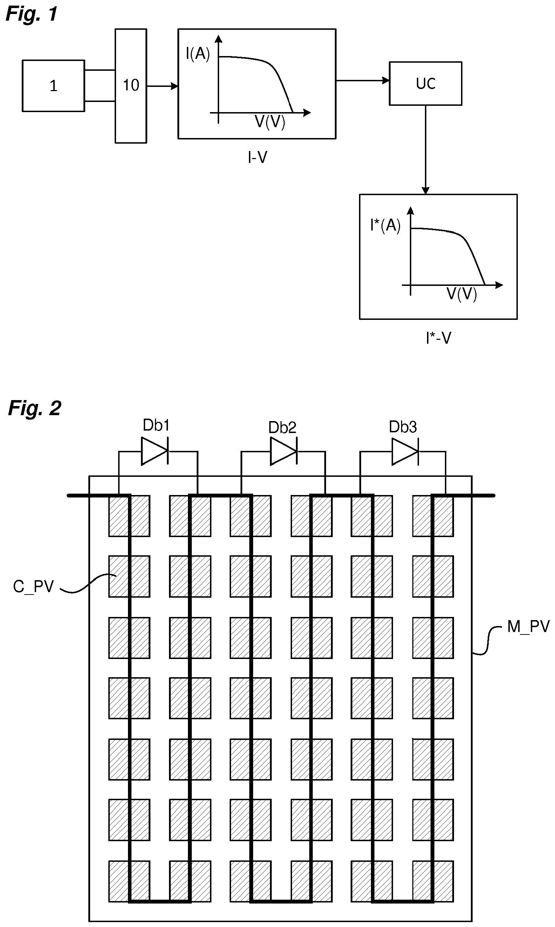

Le procédé de l'invention est mis en oeuvre grâce à un dispositif particulier qui comporte notamment des moyens de calcul réunis dans une unité de commande et de traitement UC et qui comporte des moyens de mesure 10 de type courant-tension aux bornes du système électrique surveillé. La figure 1 représente ainsi les différents moyens du dispositif pour permettre l'obtention de la courbe corrigée I*-V souhaitée.

De manière non limitative, on considère que le système électrique à considérer est un système de type photovoltaïque. Par système photovoltaïque, on entend une cellule photovoltaïque, un ensemble de plusieurs cellules photovoltaïques connectées entre elles (en série et/ou parallèle), un module photovoltaïque ou une chaîne de modules photovoltaïques.

De manière non limitative et à titre d'exemple, la figure 2 représente un module photovoltaïque M_PV composé de plusieurs cellules photovoltaïques C_PV. Sur cette figure 2, on a ainsi :

- Les cellules photovoltaïques qui sont organisées en plusieurs sous-modules. Deux rangées de cellules forment un sous-module.
- Une diode de contournement (communément désignée sous le terme "diode de bypass") Db1, Db2, Db3 distincte est associée à chaque sous-module représenté. Sur la figure 2, un sous-module est représenté avec plusieurs cellules mais il pourrait ne comporter qu'une seule cellule. La diode de contournement est destinée à contourner le sous-module en cas de défaillance d'une ou plusieurs cellules dans le sous-module.

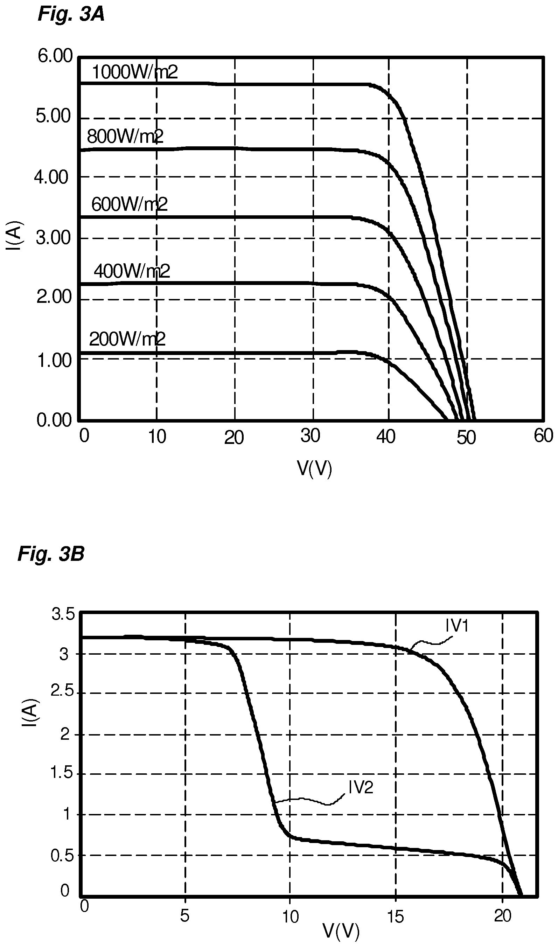

Comme évoqué précédemment, les performances d'un tel système photovoltaïque (ici un module photovoltaïque) sont caractérisées par un ensemble de courbes Courant-Tension, dénommées ci-après courbes I-V. La figure 3A représente les courbes I-V caractéristiques de référence d'un module photovoltaïque pour différents niveaux d'ensoleillement, appelés irradiance ou rayonnement et exprimés en W/m$^2$.

De manière connue, la tension totale d'une chaîne de modules photovoltaïques résulte de la somme des tensions aux bornes de chaque module (en incluant celles aux bornes des câbles et connectiques). De la même façon, la tension d'un module résulte de la somme des tensions aux bornes de chaque cellule qui compose le module puisque le module photovoltaïque est composé de plusieurs cellules mises en série. Chaque groupe de cellules est par ailleurs protégé par une diode de contournement. Aux bornes de chaque module, les tensions pourront être différentes si les modules présentent des caractéristiques I-V distinctes. En revanche, même si les modules d'une même chaîne présentent des caractéristiques I-V différentes, le fonctionnement de la chaîne sera tel que le courant de la chaîne qui traverse chaque module M_PV de la chaîne reste le même. Si une cellule est défaillante et présente un risque de point chaud ("hot spot" - fonctionnement en mode charge qui conduit à une très grande température) la diode de contournement qui protège le groupe de cellule en question permet de faire circuler le courant supplémentaire que la cellule défaillante ne peut faire passer. Le courant total fourni par le système est la somme des courants qui traversent chaque chaîne de l'architecture.

La figure 3B représente, pour un même module photovoltaïque, la courbe I-V, référencée IV1, obtenue lorsque le module photovoltaïque est sain (sans défaut) et la courbe I-V, référencée IV2, obtenue lorsque le module est défaillant. On peut notamment voir que la courbe IV2 est déformée par rapport à la courbe IV1 et en déduire que la courbe I-V mesurée pour un module permet de déterminer son état de fonctionnement.

On comprend ainsi l'importance de surveiller l'état de fonctionnement d'un système photovoltaïque (cellule, module, chaîne de cellules, chaînes de modules...) et de mettre en place un procédé qui permet d'obtenir pour ce système une courbe I-V à partir de laquelle il est possible d'établir un diagnostic fiable.

En électricité, des composants électroniques tels que l'élément capacitif et l'inductance réagissent à la variation du courant et de la tension. Lorsqu'on prend un système électrique quelconque, il est possible de retrouver dans ce système des capacités et des inductances parasites qui perturbent son signal de sortie en réponse à un autre signal d'entrée. Un exemple typique est celui des câbles électriques, dans lesquels l'inductance et la capacité parasites sont proportionnelles à la longueur et la section des câbles, au type de l'isolement et à la distance par rapport à la terre et à d'autres sources de potentiels. Dans les systèmes photovoltaïques, ce phénomène est très présent et se manifeste par des perturbations de la mesure de courbe I-V.

Comme évoqué ci-dessus, la solution de l'invention vise à corriger les mesures I-V effectuées en éliminant les effets parasites générés lors des mesures. Le principe présente un intérêt certain du fait que les mesures I-V sont réalisées sur le système photovoltaïque dans un temps très court, par exemple de l'ordre de 20ms. Dans cette situation, les effets parasites peuvent en effet être plus importants que lorsque la durée de mesure s'allonge (plusieurs secondes par exemple). Il faut cependant considérer que l'invention pourra s'appliquer dans toutes les situations de mesure, la correction à appliquer tend cependant à être moins importante (pour une technologie de cellule donnée) lorsque la durée de mesure est plus longue.

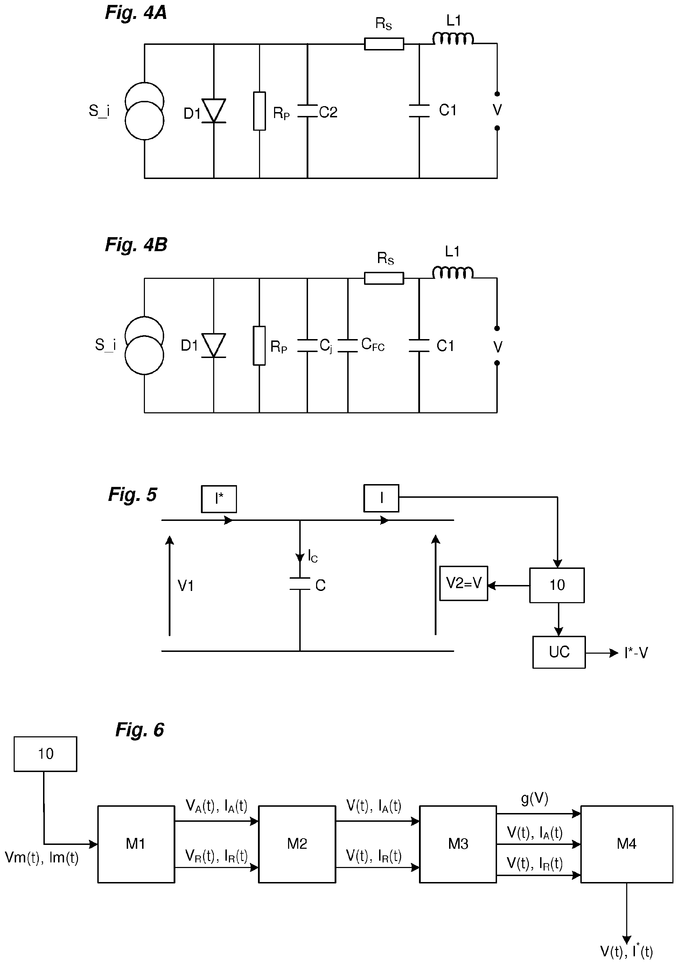

Les figures 4A et 4B représentent deux schémas de modélisation électrique d'un système électrique 1 de type photovoltaïque.

Il est en effet classique d'utiliser des modèles équivalents pour modéliser tous types de systèmes photovoltaïques. Sur la figure 4A, le modèle comporte une source de courant S_i, une diode D1, une résistance parallèle Rp et une résistance série Rs modélisant son fonctionnement. Il intègre également un condensateur dont la capacité C2 simule un effet capacitif présent dans le système photovoltaïque. Sur la figure 4B, le modèle comporte deux condensateurs en parallèle, pour modéliser les deux capacités du système photovoltaïque, c'est-à-dire la capacité de jonction Cj due à la jonction (couche séparatrice des zones + et -) des cellules photovoltaïques et la capacité des charges libres $C_{FC}$ dues aux charges libres positives et négatives des deux côtés de la jonction des cellules photovoltaïques. Sur les deux schémas, un condensateur de capacité C1, une inductance L1, et une résistance R1 ont été ajoutés pour modéliser les câbles électriques et les composants électroniques de puissance du système photovoltaïque considéré.

L'un des principes de l'invention consiste à modifier le schéma électrique équivalent classique d'un système photovoltaïque tel que défini ci-dessus en liaison avec les figures 4A et 4B (c'est-à-dire modèle à une diode avec effet capacitif). Le schéma électrique équivalent est destiné à ne représenter que l'effet parasite intrinsèque du système photovoltaïque qui se manifeste lors des mesures I-V effectuées. Ce schéma équivalent simplifié est représenté sur la figure 5.

Sur ce schéma électrique équivalent, le système est ainsi défini par une première tension V1 qui correspond à la tension du système, retirée de tout effet parasite intrinsèque (notamment capacitif) du système, un élément capacitif de capacité C qui est connecté en parallèle de ladite première tension V1 et qui représente de manière globale l'effet parasite intrinsèque susceptible de venir perturber les mesures et une deuxième tension V2 qui correspond à la tension réelle fournie par le système et incluant ledit effet parasite intrinsèque. Il est ainsi possible de manipuler directement les équations électriques aux bornes de l'élément capacitif, sans devoir connaître les valeurs de la résistance série Rs et de l'inductance L1 décrites ci-dessus.

Pour caractériser le système et ainsi obtenir une courbe I-V, on fait varier la tension aux bornes du système photovoltaïque et on mesure le courant obtenu pour chaque point de fonctionnement en tension appliqué. On obtient ainsi une courbe caractéristique du système de type courant-tension (courbe I-V).

Du fait de la présence de la capacité C, la déformation de la courbe I-V mesurée dépend du sens (croissant ou décroissant) et de la vitesse de variation de la tension. Autrement dit, dans le cadre de l'invention, il s'agit d'obtenir une première courbe I-V à une première vitesse de mesure (positive ou négative) puis une deuxième courbe I-V à une deuxième vitesse de mesure (positive ou négative), distincte de la première vitesse de mesure. De cette manière, on obtient deux courbes I-V de dynamiques différentes.

Pour la suite de la description et de manière non limitative, on peut ainsi distinguer deux sens de mesure : le sens de la tension décroissante (désigné ci-après de manière arbitraire comme le sens "Aller") et le sens de la tension croissante (désigné ci-après de manière arbitraire comme le sens "Retour"). Dans ce cas, on aura ainsi la somme de la première vitesse de mesure et de la deuxième vitesse de mesure qui est nulle.

Pour estimer la courbe caractéristique corrigée I*-V, c'est-à-dire sans l'effet parasite, on emploie les équations électriques appliquées au schéma électrique équivalent simplifié défini ci-dessus en liaison avec la figure 5.

Les équations ci-dessous décrivent respectivement la loi des noeuds et la loi des mailles appliquées aux bornes de l'élément capacitif C :

$$I^* = I - I_c \qquad\qquad (1)$$

$$I_c = \frac{d(C \times V)}{dt} = \frac{dC}{dt} \times V + C \times \frac{dV}{dt} \qquad\qquad (2)$$

Avec :

I* qui correspond au courant sans l'effet parasite ;
I qui correspond au courant intégrant l'effet parasite ;
Ic qui correspond au courant traversant l'élément capacitif du schéma équivalent ;
C qui correspond à la capacité de l'élément capacitif ;

V qui correspond à la tension de chaque point de fonctionnement en tension, intégrant l'effet parasite et correspond à la tension V2 décrite ci-dessus ;

La capacité C est une capacité apparente dont la valeur change en fonction de la tension V. Pour une facilité de manipulation mathématique des équations, on suppose que la capacité C s'écrit sous forme d'une fonction continue et dérivable (i.e. de classe $C^1$) de la tension V. Cette hypothèse est validée dans le cas du domaine d'application de type photovoltaïque. On a ainsi :

$$C = f(V) \tag{3}$$

En combinant les équations 2 et 3 on obtient :

$$I_c = f'(V) \times V \times \frac{dV}{dt} + f(V) \times \frac{dV}{dt} \tag{4}$$

L'équation (3) peut être écrite sous la forme :

$$I_c = g(V) \times \frac{dV}{dt} \tag{5}$$

Avec :

$$g(V) = f'(V) \times V + f(V) \tag{6}$$

La grandeur g(V) a la dimension d'une capacité. On peut ainsi dire que cette fonction correspond à une capacité corrigée de la capacité C.

En combinant les équations (1) et (5), on obtient :

$$I^* = I - g(V) \times \frac{dV}{dt} \tag{7}$$

En appliquant l'équation (7) aux courbes Aller et Retour (IA-$V_A$ et $I_R$-$V_R$) on obtient :

$$I^*(V_A) = I_A(V_A) - g(V_A) \times \frac{dV_A}{dt}(V_A) \tag{8}$$

$$I^*(V_R) = I_R(V_R) - g(V_R) \times \frac{dV_R}{dt}(V_R) \tag{9}$$

Le système d'équations (8) et (9) est un système à deux égalités et à deux inconnus. Pour pouvoir le résoudre, il peut être nécessaire de réévaluer les fonctions $I_R(V_R)$, $I_A(V_A)$, $dV_R/dt^*(V_R)$ et $dV_A/dt^*(V_A)$ aux mêmes points de fonctionnement en tension. Une fois cela réalisé, la solution du système d'équation est obtenue en utilisant les équations (10) et (11) ci-dessous :

$$g(V) = \frac{I_A(V) - I_R(V)}{\frac{dV_R}{dt}(V) - \frac{dV_A}{dt}(V)} \tag{10}$$

$$I^* = I(V) - g(V) \times \frac{dV}{dt}(V) \tag{11}$$

Selon un aspect particulier de l'invention, on peut noter que les équations détaillées ci-dessus peuvent également permettre de déterminer la valeur de la capacité C du schéma équivalent, en tenant compte du calcul de g(V). La valeur de la capacité C, définie par la relation C=f(V), peut être obtenue en résolvant l'équation différentielle (12) ci-dessous. La solution de cette équation s'écrit sous la forme décrite par l'équation (13) :

$$f(V) + V.f'(V) = g(V) \tag{12}$$

$$C = f(V) = \frac{\Gamma(V) + \Gamma_0}{|V|} \tag{13}$$

Avec $\Gamma_0$ une constante déterminée par les conditions initiales, et $\Gamma$ la primitive de la fonction g(V).

En appliquant les principes de l'invention décrits ci-dessus, la courbe corrigée obtenue est donc une courbe sans effet parasite, dans laquelle les courbes Aller et Retour sont superposées. Les effets parasites, qui ont tendance à décaler la courbe Retour vers le haut et décaler la courbe Aller vers le bas, disparaissent complétement dans la courbe I-V corrigée, et les deux courbes Aller et Retour ne font plus qu'une après la correction.

Il est noté ici que la connaissance du schéma électrique équivalent n'est pas nécessaire pour corriger l'effet parasite puisque l'invention propose une réécriture du schéma électrique qui permet de rendre indépendant l'effet parasite du reste du système

La figure 6 illustre ainsi les étapes principales qui sont mises en œuvre pour parvenir à la courbe corrigée I*-V souhaitée.

Dans une première étape, mise en œuvre par l'unité de commande et de traitement UC, le procédé consiste à commander les moyens de mesure 10 du dispositif afin de recueillir les données de courant en fonction de la tension. Comme déjà décrit ci-dessus, les mesures peuvent être effectuées dans un temps très court, par exemple de l'ordre de 20ms, ce qui permet de ne pas perturber le fonctionnement du système photovoltaïque, ni d'avoir à tenir compte des variations des conditions environnementales (ensoleillement, température...). Les données de mesure obtenues sont référencées Vm(t) et Im(t). Les données sont générées dans les deux sens déjà définis ci-dessus, c'est-à-dire dans le sens aller (tension croissante) et dans le sens retour (tension décroissante).

Dans une deuxième étape, l'unité de commande et de traitement traite ensuite ces données. Un premier module M1 de l'unité de commande et de traitement UC est chargé de séparer les données obtenues pour générer la courbe aller et la courbe retour. La courbe aller est ainsi définie par les données de mesure $V_A(t)$, IA(t) et la courbe retour par les données de mesure $V_R(t)$, $I_R(t)$.

Dans une troisième étape, l'unité de commande et de traitement UC exécute un module M2 pour assurer une unification des points de fonctionnement en tension sur les deux courbes aller et retour. Ainsi, pour chaque point de fonctionnement en tension V, l'unité de commande et de traitement UC dispose d'une valeur de courant appartenant à la courbe aller et d'une valeur de courant appartenant à la courbe retour. Pour réaliser cette unification, le module M3 peut être amené à mettre en place le principe d'interpolation évoqué ci-dessus. L'unité de commande et de traitement UC dispose ainsi des données V(t), IA(t) pour la courbe aller et des données V(t), IR(t) pour la courbe retour.

Dans une quatrième étape, l'unité de commande et de traitement UC exécute un module M3 pour déterminer la valeur de correction à appliquer pour chaque point de fonctionnement en tension, cette valeur de correction étant définie par la fonction g(V) exprimée dans la relation (10) ci-dessus.

Dans une cinquième étape, l'unité de commande et de traitement UC exécute un module M4 chargé de déterminer la courbe corrigée I*-V en appliquant la valeur de correction identifiée pour chaque point de fonctionnement en tension au courant correspondant. La relation (11) ci-dessus est ainsi appliquée :

$$I^* = I(V) - g(V) \times \frac{dV}{dt}(V)$$

De manière optionnelle, l'unité de commande et de traitement UC peut être amenée à calculer la valeur de la capacité C en appliquant la relation (13) évoquée ci-dessus.

Pour valider la méthode de correction de l'effet capacitif proposée ci-dessus, des tests ont été effectués sur des courbes I-V mesurées sur un système photovoltaïque. Le système photovoltaïque monitoré dans ce cas est une chaîne de modules, qui possède les caractéristiques résumées dans le tableau ci-dessous.

| Système photovoltaïque | Chaîne composée de 14 modules PV |
|---|---|
| Technologie | Poly-cristallin |
| Puissance crête par module | 205Wc |
| Tension circuit-ouvert par module | 32.7V |
| Courant court-circuit par module | 8A |
| Nombre de diodes de bypass par module | 3 |
| Nombre de cellules par module | 60 |
| Conditions | Extérieur |
| Durée du tracé de la courbe | 20ms |

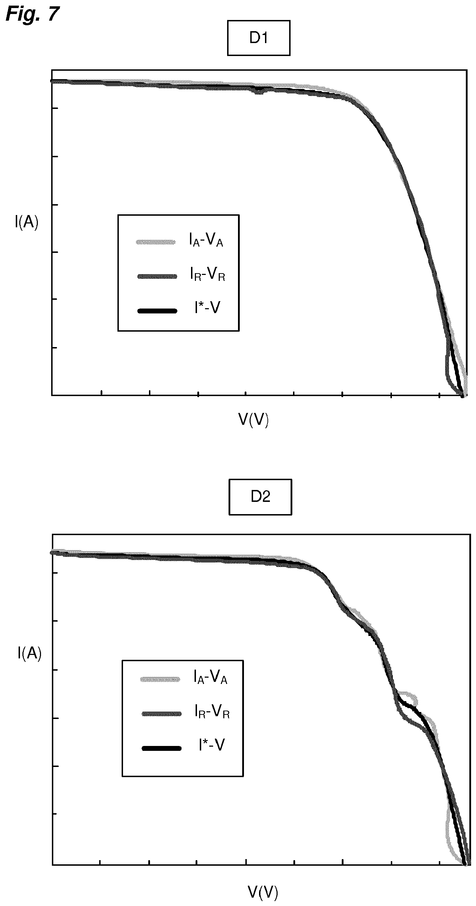

Le principe de l'invention décrit ci-dessus est appliqué pour corriger des courbes I-V mesurées sur une période très courte (de l'ordre de 20ms). On obtient alors les deux diagrammes D1, D2 de la figure 7. Le diagramme D1 de la figure 7 est un cas où le système photovoltaïque étudié ne subit pas d'ombrage et le diagramme D2 est un cas où le système photovoltaïque subit un ombrage.

Sur ces deux diagrammes D1, D2, on peut voir que les deux courbes $I_A$-$V_A$ et $I_R$-$V_R$ mesurées dans le sens aller et dans le sens retour ne sont pas superposées. Ceci est dû à la présence d'un effet capacitif.

Sur ces deux diagrammes, on peut voir également la courbe corrigée I*-V déterminée par le principe de l'invention.

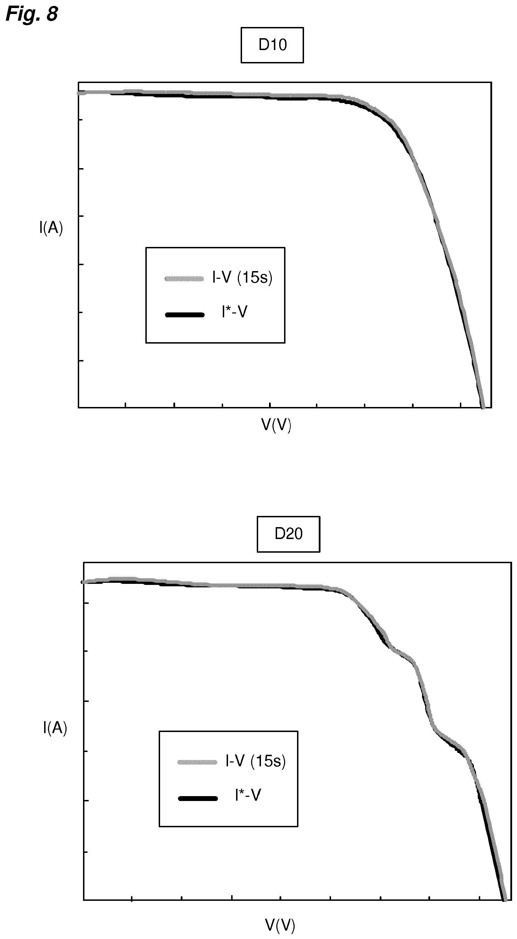

La figure 8 représente également deux diagrammes D10, D20 (sans ombrage et avec ombrage) montrant chacun la courbe I-V obtenue après un temps de mesure plus long (de l'ordre de 15 secondes), cette dernière courbe étant ainsi supposée sans effet parasite (car mesurée sur une durée plus longue - l'effet capacitif devenant négligeable dans cette situation de mesure). On peut ainsi voir que la courbe corrigée I*-V suit parfaitement la courbe I-V mesurée sur la durée plus longue, montrant que la solution de l'invention est fiable et même adaptable quelle que soit la durée prise pour la mesure de la courbe I-V.

On comprend que la solution de l'invention présente de nombreux avantages, parmi lesquels :

- Une solution simple à mettre en œuvre,
- Une solution adaptable quelle que soit la durée des mesures I-V mises en œuvre,
- Une solution adaptable à des temps de mesure très courts, ce qui permet de s'affranchir des variations des conditions environnementales mais aussi de ne pas perturber le fonctionnement normal du système (notamment par la déconnexion du système pour effectuer les mesures), d'éviter des pertes énergétiques et de limiter la chaleur à dissiper,
- Une solution fiable, permettant d'obtenir des courbes I-V corrigées exploitables pour diagnostiquer l'état du système.

**Revendications**

1. Procédé de détermination d'une courbe courant-tension corrigée (I*-V) d'un système électrique (1) qui comporte deux bornes et qui est destiné à délivrer un courant électrique en fonction d'une tension de sortie (V2) entre ses deux bornes, **caractérisé en ce qu'**il comporte les étapes suivantes :

   - Obtention d'une première courbe courant-tension ($I_A$-$V_A$) caractéristique du système électrique, en faisant varier la tension à ses bornes à une première vitesse de mesure,
   - Obtention d'une deuxième courbe courant-tension ($I_R$-$V_R$) caractéristique du système électrique, en faisant varier la tension à ses bornes à une deuxième vitesse de mesure, différente de la première vitesse,
   - Détermination de plusieurs points de fonctionnement en tension appartenant à la fois à la première courbe courant-tension et à la deuxième courbe courant-tension,
   - Modélisation par une unique capacité fictive (C) d'un effet parasite intrinsèque à corriger entre une tension d'entrée (V1) dépourvue dudit effet parasite et ladite tension de sortie (V2),
   - Et **en ce qu'**il comporte, pour chaque point de fonctionnement en tension (V), une étape de détermination d'une valeur de correction représentative dudit effet parasite et une étape de détermination d'une valeur de courant corrigée à partir de la valeur de correction déterminée.

**2.** Procédé selon la revendication 1, **caractérisé en ce que** la première courbe courant-tension est obtenue en faisant varier la tension dans le sens croissant et **en ce que** la deuxième courbe courant-tension est obtenue en faisant varier la tension dans le sens décroissant.

**3.** Procédé selon la revendication 1 ou 2, **caractérisé en ce que** le système électrique est de type photovoltaïque et **en ce que** le procédé comporte :

- Pour chaque point de fonctionnement en tension (V) obtenu, une étape de détermination, à partir de la première courbe courant-tension ($I_A$-$V_A$), d'un premier courant et d'une première pente de variation de tension en fonction du temps et une étape de détermination, à partir de la deuxième courbe courant-tension ($I_R$-$V_R$), d'un deuxième courant et d'une deuxième pente de variation de tension en fonction du temps, et **en ce que**
- Pour chaque point de fonctionnement en tension (V), ladite valeur de correction est déterminée à partir dudit premier courant, de ladite première pente, dudit deuxième courant et de ladite deuxième pente.

**4.** Procédé selon la revendication 3, **caractérisé en ce que** ladite valeur de correction dudit effet parasite s'exprime par la relation suivante :

$$g(V) = \frac{I_A(V) - I_R(V)}{\frac{dV_R}{dt}(V) - \frac{dV_A}{dt}(V)}$$

Dans laquelle :

g(V) correspond audit effet parasite à éliminer ;
$I_A$(V) correspond audit premier courant ;
$I_R$(V) correspond audit deuxième courant ;

$\frac{dV_A}{dt}(V)$ correspond à ladite première pente ;

$\frac{dV_R}{dt}(V)$ correspond à ladite deuxième pente ;

**5.** Procédé selon l'une des revendications 1 à 4, **caractérisé en ce que** l'étape de détermination de plusieurs points de fonctionnement en tension appartenant à la fois à la première courbe courant-tension ($I_A$-$V_A$) et à la deuxième courbe courant-tension ($I_R$-$V_R$) est mise en œuvre en employant une méthode d'interpolation.

**6.** Dispositif de détermination d'une courbe courant-tension corrigée (I*-V) d'un système électrique (1) qui comporte deux bornes et qui est destiné à délivrer un courant électrique en fonction d'une tension de sortie (V2) entre ses deux bornes, ledit dispositif étant **caractérisé en ce qu'**il comporte :

- Des moyens de mesure (10) d'une première courbe courant-tension ($I_A$-$V_A$) caractéristique du système électrique, en faisant varier la tension à ses bornes à une première vitesse de mesure,
- Des moyens de mesure (10) d'une deuxième courbe courant-tension ($I_R$-$V_R$) caractéristique du système électrique, en faisant varier la tension à ses bornes à une deuxième vitesse de mesure, distincte de la première vitesse de mesure,
- Un module (M2) de détermination de plusieurs points de fonctionnement en tension appartenant à la fois à la première courbe courant-tension et à la deuxième courbe courant-tension,
- Un module de modélisation par une unique capacité fictive (C) d'un effet parasite à corriger entre une tension d'entrée (V1) dépourvue dudit effet parasite et ladite tension de sortie (V2),
- Et **en ce qu'**il exécute, pour chaque point de fonctionnement en tension (V), un module (M3) de détermination d'une valeur de correction représentative dudit effet parasite et un module de détermination d'une valeur de courant corrigée à partir de la valeur de correction déterminée.

**7.** Dispositif selon la revendication 6, **caractérisé en ce que** la première courbe courant-tension est obtenue en faisant varier la tension dans le sens croissant et **en ce que** la deuxième courbe courant-tension est obtenue en faisant varier la tension dans le sens décroissant.

8. Dispositif selon la revendication 6, **caractérisé en ce que** le système électrique est de type photovoltaïque et **en ce que** le dispositif comporte :

- Pour chaque point de fonctionnement en tension (V) obtenu, un module de détermination, à partir de la première courbe courant-tension ($I_A$-$V_A$), d'un premier courant et d'une première pente de variation de tension en fonction du temps et un module de détermination, à partir de la deuxième courbe courant-tension ($I_R$-$V_R$), d'un deuxième courant et d'une deuxième pente de variation de tension en fonction du temps, et **en ce que**
- Pour chaque point de fonctionnement en tension (V), ladite valeur de correction est déterminée à partir dudit premier courant, de ladite première pente, dudit deuxième courant et de ladite deuxième pente.

9. Dispositif selon la revendication 8, **caractérisé en ce que** ladite valeur de correction dudit effet parasite s'exprime par la relation suivante :

$$g(V) = \frac{I_A(V) - I_R(V)}{\frac{dV_R}{dt}(V) - \frac{dV_A}{dt}(V)}$$

Dans laquelle :

g(V) correspond audit effet parasite à éliminer ;
$I_A$(V) correspond audit premier courant ;
$I_R$(V) correspond audit deuxième courant ;

$\frac{dV_A}{dt}(V)$ correspond à ladite première pente ;

$\frac{dV_R}{dt}(V)$ correspond à ladite deuxième pente ;

10. Dispositif selon l'une des revendications 1 à 8, **caractérisé en ce que** le module de détermination de plusieurs points de fonctionnement en tension appartenant à la fois à la première courbe courant-tension ($I_A$-$V_A$) et à la deuxième courbe courant-tension ($I_R$-$V_R$) est configuré pour mettre en œuvre une méthode d'interpolation.

11. Utilisation du procédé tel que défini dans l'une des revendications 1 à 5 pour déterminer la courbe courant-tension caractéristique d'un système électrique de type photovoltaïque.

**Patentansprüche**

1. Verfahren zur Bestimmung einer korrigierten Strom-Spannungs-Kurve (I*-V) eines elektrischen Systems (1), das zwei Anschlüsse umfasst und das dazu bestimmt ist, in Abhängigkeit von einer Ausgangsspannung (V2) zwischen seinen zwei Anschlüssen einen elektrischen Strom zu liefern, **dadurch gekennzeichnet, dass** es die folgenden Schritte beinhaltet:

- Erhalten einer ersten Strom-Spannungs-Kurve ($I_A$-$V_A$), die für das elektrische System charakteristisch ist, indem an dessen Anschlüssen die Spannung mit einer ersten Messgeschwindigkeit verändert wird,
- Erhalten einer zweiten Strom-Spannungs-Kurve ($I_R$-$V_R$), die für das elektrische System charakteristisch ist, indem an dessen Anschlüssen die Spannung mit einer zweiten Messgeschwindigkeit, die sich von der ersten Geschwindigkeit unterscheidet, verändert wird,
- Bestimmen mehrerer Arbeitspunkte der Spannung, die sowohl zu der ersten Strom-Spannungs-Kurve als auch zu der zweiten Strom-Spannungs-Kurve gehören,
- Modellieren, durch eine einzelne fiktive Kapazität (C), eines intrinsischen parasitären Effekts, der zwischen einer Eingangsspannung (V1), die diesen parasitären Effekt nicht aufweist, und der Ausgangsspannung (V2) zu korrigieren ist,
- und dadurch, dass es für jeden Arbeitspunkt der Spannung (V) einen Schritt des Bestimmens eines Korrekturwerts, der für den parasitären Effekt repräsentativ ist, und einen Schritt des Bestimmens eines korrigierten Stromwerts auf Basis des bestimmten Korrekturwerts umfasst.

**2.** Verfahren nach Anspruch 1, **dadurch gekennzeichnet, dass** die erste Strom-Spannungs-Kurve erhalten wird, indem die Spannung in zunehmender Richtung verändert wird, und dass die zweite Strom-Spannungs-Kurve erhalten wird, indem die Spannung in abnehmender Richtung verändert wird.

**3.** Verfahren nach Anspruch 1 oder 2, **dadurch gekennzeichnet, dass** das elektrische System von einem photovoltaischen Typ ist und dass das Verfahren Folgendes umfasst:

- für jeden erhaltenen Arbeitspunkt der Spannung (V), einen Schritt des Bestimmens, auf Basis der ersten Strom-Spannungs-Kurve ($I_A$-$V_A$), eines ersten Stroms und einer ersten Steigung der Spannungsveränderung in Abhängigkeit von der Zeit und einen Schritt des Bestimmens, auf Basis der zweiten Strom-Spannungs-Kurve ($I_R$-$V_R$), eines zweiten Stroms und einer zweiten Steigung der Spannungsveränderung in Abhängigkeit von der Zeit, und dadurch, dass
- für jeden Arbeitspunkt der Spannung (V) der Korrekturwert auf Basis des ersten Stroms, der ersten Steigung, des zweiten Stroms und der zweiten Steigung bestimmt wird.

**4.** Verfahren nach Anspruch 3, **dadurch gekennzeichnet, dass** der Korrekturwert des parasitären Effekts durch die folgende Gleichung ausgedrückt wird:

$$g(V) = \frac{I_A(V) - I_R(V)}{\frac{dV_R}{dt}(V) - \frac{dV_A}{dt}(V)}$$

Wobei:

g(V) dem zu eliminierenden parasitären Effekt entspricht;
$I_A(V)$ dem ersten Strom entspricht;
$I_R(V)$ dem zweiten Strom entspricht;
$\frac{dV_A}{dt}(V)$ der ersten Steigung entspricht;
$\frac{dV_R}{dt}(V)$ der zweiten Steigung entspricht.

**5.** Verfahren nach einem der Ansprüche 1 bis 4, **dadurch gekennzeichnet, dass** der Schritt des Bestimmens mehrerer Arbeitspunkte der Spannung, die sowohl zu der ersten Strom-Spannungs-Kurve ($I_A$-$V_A$) als auch zu der zweiten Strom-Spannungs-Kurve ($I_R$-$V_R$) gehören, durch das Anwenden einer Interpolationsmethode umgesetzt wird.

**6.** Vorrichtung zur Bestimmung einer korrigierten Strom-Spannungs-Kurve (I\*-V) eines elektrischen Systems (1), das zwei Anschlüsse umfasst und das dazu bestimmt ist, in Abhängigkeit von einer Ausgangsspannung (V2) zwischen seinen zwei Anschlüssen einen elektrischen Strom zu liefern, wobei die Vorrichtung **dadurch gekennzeichnet ist, dass** sie Folgendes umfasst:

- Mittel zum Messen (10) einer ersten Strom-Spannungs-Kurve ($I_A$-$V_A$), die für das elektrische System charakteristisch ist, indem an dessen Anschlüssen die Spannung mit einer ersten Messgeschwindigkeit verändert wird,
- Mittel zum Messen (10) einer zweiten Strom-Spannungs-Kurve ($I_R$-$V_R$), die für das elektrische System charakteristisch ist, indem an dessen Anschlüssen die Spannung mit einer zweiten Messgeschwindigkeit, die von der ersten Geschwindigkeit verschieden ist, verändert wird,
- ein Modul (M2) zur Bestimmung mehrerer Arbeitspunkte der Spannung, die sowohl zu der ersten Strom-Spannungs-Kurve als auch zu der zweiten Strom-Spannungs-Kurve gehören,
- ein Modul zum Modellieren, durch eine einzelne fiktive Kapazität (C), eines parasitären Effekts, der zwischen einer Eingangsspannung (V1), die diesen parasitären Effekt nicht aufweist, und der Ausgangsspannung (V2) zu korrigieren ist,
- und dadurch, dass sie für jeden Arbeitspunkt der Spannung (V) ein Modul (M3) zur Bestimmung eines Korrekturwerts, der für den parasitären Effekt repräsentativ ist, und ein Modul zur Bestimmung eines korrigierten Stromwerts auf Basis des bestimmten Korrekturwerts ausführt.

**7.** Vorrichtung nach Anspruch 6, **dadurch gekennzeichnet, dass** die erste Strom-Spannungs-Kurve erhalten wird, indem die Spannung in zunehmender Richtung verändert wird, und dass die zweite Strom-Spannungs-Kurve erhalten wird, indem die Spannung in abnehmender Richtung verändert wird.

8. Vorrichtung nach Anspruch 6, **dadurch gekennzeichnet, dass** das elektrische System von einem photovoltaischen Typ ist und dass die Vorrichtung Folgendes umfasst:

- für jeden erhaltenen Arbeitspunkt der Spannung (V), ein Modul zur Bestimmung, auf Basis der ersten Strom-Spannungs-Kurve ($I_A$-$V_A$), eines ersten Stroms und einer ersten Steigung der Spannungsveränderung in Abhängigkeit von der Zeit und ein Modul zur Bestimmung, auf Basis der zweiten Strom-Spannungs-Kurve ($I_R$-$V_R$), eines zweiten Stroms und einer zweiten Steigung der Spannungsveränderung in Abhängigkeit von der Zeit, und dadurch, dass
- für jeden Arbeitspunkt der Spannung (V) der Korrekturwert auf Basis des ersten Stroms, der ersten Steigung, des zweiten Stroms und der zweiten Steigung bestimmt wird.

9. Vorrichtung nach Anspruch 8, **dadurch gekennzeichnet, dass** der Korrekturwert des parasitären Effekts durch die folgende Gleichung ausgedrückt wird:

$$g(V) = \frac{I_A(V) - I_R(V)}{\frac{dV_R}{dt}(V) - \frac{dV_A}{dt}(V)}$$

Wobei:

g(V) dem zu eliminierenden parasitären Effekt entspricht;
$I_A$(V) dem ersten Strom entspricht;
$I_R$(V) dem zweiten Strom entspricht;
$\frac{dV_A}{dt}$ (V) der ersten Steigung entspricht;
$\frac{dV_R}{dt}$ (V) der zweiten Steigung entspricht.

10. Vorrichtung nach einem der Ansprüche 1 bis 8, **dadurch gekennzeichnet, dass** das Modul zur Bestimmung mehrerer Arbeitspunkte der Spannung, die sowohl zu der ersten Strom-Spannungs-Kurve ($I_A$-$V_A$) als auch zu der zweiten Strom-Spannungs-Kurve ($I_R$-$V_R$) gehören, dazu konfiguriert ist, eine Interpolationsmethode umzusetzen.

11. Verwendung des Verfahrens wie in einem der Ansprüche 1 bis 5 definiert, um die Strom-Spannungs-Kurve, die für ein elektrisches Systems von einem photovoltaischen Typ charakteristisch ist, zu bestimmen.

**Claims**

1. Method for determining a corrected current-voltage curve (I*-V) of an electrical system (1) which comprises two terminals and which is intended to deliver an electrical current as a function of an output voltage (V2) between its two terminals, **characterized in that** it comprises the following steps:

- obtaining a first current-voltage characteristic curve ($I_A$-$V_A$) of the electrical system, by varying the voltage at its terminals with a first measurement speed,
- obtaining a second current-voltage characteristic curve ($I_R$-$V_R$) of the electrical system, by varying the voltage at its terminals with a second measurement speed, different from the first speed,
- determining several voltage operating points belonging to both the first current-voltage curve and the second current-voltage curve,
- modelling, via a single hypothetical capacitance (C), an intrinsic stray effect to be corrected between an input voltage (V1) without said stray effect and said output voltage (V2),
- and **in that** it comprises, for each voltage (V) operating point, a step of determining a correction value representative of said stray effect and a step of determining a corrected current value from the determined correction value.

EP 3 660 524 B1

2. Method according to Claim 1, **characterized in that** the first current-voltage curve is obtained by varying the voltage in the increasing direction and **in that** the second current-voltage curve is obtained by varying the voltage in the decreasing direction.

3. Method according to Claim 1 or 2, **characterized in that** the electrical system is of photovoltaic type and **in that** the method comprises:

- for each voltage (V) operating point obtained, a step of determining, from the first current-voltage curve ($I_A$-$V_A$), a first current and a first slope of voltage variation as a function of time and a step of determining, from the second current-voltage curve ($I_R$-$V_R$), a second current and a second slope of voltage variation as a function of time, and **in that**
- for each voltage (V) operating point, said correction value is determined from said first current, from said first slope, from said second current and from said second slope.

4. Method according to Claim 3, **characterized in that** said correction value of said stray effect is expressed by the following relationship:

$$g(V) = \frac{I_A(V) - I_R(V)}{\frac{dV_R}{dt}(V) - \frac{dV_A}{dt}(V)}$$

in which:

g(V) corresponds to said stray effect to be eliminated;
$I_A(V)$ corresponds to said first current;
$I_R(V)$ corresponds to said second current;

$\frac{dV_A}{dt}(V)$ corresponds to said first slope;

$\frac{dV_R}{dt}(V)$ corresponds to said second slope.

5. Method according to one of Claims 1 to 4, **characterized in that** the step of determining several voltage operating points belonging to both the first current-voltage curve ($I_A$-$V_A$) and the second current-voltage curve ($I_R$-$V_R$) is implemented by employing an interpolation method.

6. Device for determining a corrected current-voltage curve (I*-V) of an electrical system (1) which comprises two terminals and which is intended to deliver an electrical current as a function of an output voltage (V2) between its two terminals, said device being **characterized in that** it comprises:

- means (10) for measuring a first current-voltage characteristic curve ($I_A$-$V_A$) of the electrical system, by varying the voltage at its terminals with a first measurement speed,
- means (10) for measuring a second current-voltage characteristic curve ($I_R$-$V_R$) of the electrical system, by varying the voltage at its terminals with a second measurement speed, distinct from the first measurement speed,
- a module (M2) for determining several voltage operating points belonging to both the first current-voltage curve and the second current-voltage curve,
- a module for modelling, via a single hypothetical capacitance (C), a stray effect to be corrected between an input voltage (V1) without said stray effect and said output voltage (V2),
- and **in that** it executes, for each voltage (V) operating point, a module (M3) for determining a correction value representative of said stray effect and a module for determining a corrected current value from the determined correction value.

7. Device according to Claim 6, **characterized in that** the first current-voltage curve is obtained by varying the voltage in the increasing direction and **in that** the second current-voltage curve is obtained by varying the voltage in the decreasing direction.

14

8. Device according to Claim 6, **characterized in that** the electrical system is of photovoltaic type and **in that** the device comprises:

- for each voltage (V) operating point obtained, a module for determining, from the first current-voltage curve ($I_A$-$V_A$), a first current and a first slope of voltage variation as a function of time and a module for determining, from the second current-voltage curve ($I_R$-$V_R$), a second current and a second slope of voltage variation as a function of time, and **in that**
- for each voltage (V) operating point, said correction value is determined from said first current, from said first slope, from said second current and from said second slope.

9. Device according to Claim 8, **characterized in that** said correction value of said stray effect is expressed by the following relationship:

$$g(V) = \frac{I_A(V) - I_R(V)}{\frac{dV_R}{dt}(V) - \frac{dV_A}{dt}(V)}$$

in which:

g(V) corresponds to said stray effect to be eliminated;
$I_A(V)$ corresponds to said first current;
$I_R(V)$ corresponds to said second current;

$\frac{dV_A}{dt}(V)$ corresponds to said first slope;

$\frac{dV_R}{dt}(V)$ corresponds to said second slope.

10. Device according to one of Claims 1 to 8, **characterized in that** the module for determining several voltage operating points belonging to both the first current-voltage curve ($I_A$-$V_A$) and the second current-voltage curve ($I_R$-$V_R$) is configured to implement an interpolation method.

11. Use of a method as defined in one of Claims 1 to 5 to determine the current-voltage curve characteristic of an electrical system of photovoltaic type.

**Fig. 1**

I-V

I*-V

**Fig. 2**

*Fig. 3A*

*Fig. 3B*

**Fig. 4A**

**Fig. 4B**

**Fig. 5**

**Fig. 6**

*Fig. 7*

*Fig. 8*

D10

I(A)

I-V (15s)

I*-V

V(V)

D20

I(A)

I-V (15s)

I*-V

V(V)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015094967 A1
- WO 2012128807 A1
- FR 2956213 A1
- WO 2010118952 A1
- US 9048781 B2
- JP 58077672 A
- US 2014266294 A1

**Littérature non-brevet citée dans la description**

- PV Module Parameter Characterization from the transient charge of an external capacitor. **SPERTINO FILIPPO et al.** IEEE Journal of photovoltaics. IEEE, 01 Octobre 2013, vol. 3, 1325-1333